# EUROPEAN PATENT APPLICATION

(11) **EP 2 579 029 A1**
(43) Date of publication of application: **10.04.2013**
(21) Application number: 11789613.4
(22) Date of filing: 17.05.2011
(51) Int. Cl.: G01N 25/72, G01R 31/26, H01L 25/07, H01L 25/18

(54) **METHOD FOR MANUFACTURING SEMICONDUCTOR DEVICE**

(30) Priority: 03.06.2010 JP 2010128196
(71) Applicant: Sumitomo Electric Industries, Ltd., Chuo-ku Osaka-shi Osaka 541-0041 (JP)
(72) Inventor: HATSUKAWA Satoshi, Osaka-shi Osaka 554-0024 (JP)
(74) Representative: Grünecker, Kinkeldey, Stockmair & Schwanhäusser
(86) International application number: PCT/JP2011/061322
(87) International publication number: WO 2011/152204

(57) **Abstract**

A plurality of SiC semiconductor chips are mounted on a mounting substrate (S1), and a voltage is applied to the SiC semiconductor chips on the mounting substrate (S2). In the state in which the voltage is applied, thermography, infrared microscope, or another thermal imaging device is used to acquire a temperature distribution image of the surface of the mounting substrate (S3), and by conducting image analysis, the presence of a defective chip is determined (S5). If a defective chip is included on the mounting substrate ("YES" in S5), wiring of the defective chip is severed to exclude the defective chip (S7). By this means, a method for manufacturing a semiconductor device using small-capacity chips is provided.

## Description

### Technical Field

This invention relates to a method for manufacturing a semiconductor device using a low-capacity chip.

### Background Art

Silicon carbide (SiC) has such excellent properties as high hardness, heat resistance and chemical stability, and is attracting attention as a semiconductor material as well. In recent years power devices using SiC semiconductors have been practically applied.

In order to increase the capacity (increase the current) of a power device using a SiC semiconductor, the chip area must be enlarged, but because the manufacturing yield for the withstand voltage falls sharply, at present only small-capacity chips are commercialized.

In order to use such low-capacity chips in large-current applications, semiconductor devices have been proposed in which numerous small-capacity chips are connected in parallel (see for example Patent Literature 1).

### Citation List

### Patent Literature

Patent Literature 1: Japanese Patent Application Laid-open No. 2004-95670

### Summary of Invention

### Technical Problem

In a case where the feature disclosed in Patent Literature 1 is used, a large current can be passed by connecting numerous small-capacity SiC diodes in parallel, but the manufacturing yield at the time of mounting worsens, and consequently in order to obtain the required number of semiconductor devices, a greater number of semiconductor devices than the required number must be fabricated.

A compound semiconductor of SiC or similar cannot be manufactured as a large chip due to the substrate quality, and only small-capacity devices are possible. In order to obtain a large-current device, numerous small-capacity chips must be connected in parallel, as for example disclosed in Patent Literature 1. Satisfactory items which have passed inspections are used as the small-capacity chips mounted on a substrate, but heat is applied during mounting, so that even when satisfactory items are used, defects occur in a constant fraction thereof. If the manufacturing yield when mounting one small-capacity chip is a (0 ≤ a ≤ 1), then the manufacturing yield when mounting n small-capacity chips to form a large-current device is aⁿ. In this way, there is the problem that when numerous small-capacity chips are mounted to increase the current capacity, the manufacturing yield worsens exponentially.

Hence in order to manufacture m large-capacity devices, on average it is necessary to fabricate m/aⁿ substrates.

Further, because it is not possible to discriminate defective chips from the external appearance, it is difficult to visually identify and exclude defective chips. Moreover, in the case of chips which can be made large such as those of silicon, the chips themselves can be inspected at the time of manufacture and the presence of defects determined, so that it is possible to use only satisfactory items; but in the case of semiconductor chips such as those of SiC which cannot be made large, as described above, inspection of individual chips is not easy.

This invention has as an object the provision of a method for manufacturing semiconductor devices which enables visual identification of defective chips occurring in a mounting step, and exclusion of the defective chips.

### Solution to Problem

The method for manufacturing semiconductor devices of one embodiment includes a step of forming, on a substrate, a circuit formed of a plurality of semiconductor elements connected in parallel, and an inspection step of inspecting semiconductor elements forming the circuit, and is characterized in that the inspection step includes a step of applying a voltage to each of the semiconductor elements included in the circuit formed on the substrate, a step of detecting whether there is heat generation in each of the semiconductor elements as a result of the application of a voltage, and a step of severing the connection between a semiconductor element for which heat generation has been detected and another semiconductor element.

In this method of manufacturing, even after the plurality of semiconductor elements have all been installed onto the mounting substrate, defects occurring at the time of mounting can be detected by the presence of heat generation in each of the semiconductor elements, and by excluding only a semiconductor element in which a defect has occurred, only the remaining semiconductor elements are used, and a normally functioning semiconductor device is obtained.

The method for manufacturing semiconductor devices of one embodiment may be characterized in that the semiconductor elements are elements including SiC, GaN, or diamond.

In this manufacturing method, even when it is difficult to enlarge the chip area and semiconductor elements with small current capacities are used, by connecting numerous semiconductor elements in parallel, a large current capacity is realized for the device overall.

The method for manufacturing semiconductor devices of one embodiment may be characterized in that the semiconductor elements are diodes or transistors.

In this manufacturing method, a plurality of diodes or transistors are connected in parallel to configure a semiconductor device, so that even when the current capacities of each of the semiconductor elements are small, a large current capacity is realized for the device overall.

The method for manufacturing semiconductor devices of one embodiment may be characterized in that the presence of heat generation in each of the semiconductor elements is detected by thermography, by an infrared microscope, or by a temperature sensor.

When using thermography or infrared microscope as means to detect the presence of heat generation in a semiconductor element, the presence of heat generation is detected by analyzing the temperature distribution image generated by these thermal imaging devices. When using a thermocouple, thermistor, or other temperature sensor as means of detecting the presence of heat generation in semiconductor elements, the presence of heat generation is detected by a change in voltage, for example.

The method for manufacturing semiconductor devices of one embodiment may be characterized in that a thermolabel or thermopaint is attached to each of the semiconductor elements, and the presence of heat generation in each of the semiconductor elements is detected by a change in color of the thermolabels or thermopaint.

In this manufacturing method, the presence of heat generation in each semiconductor element is detected by a change in color of the thermolabels, or thermopaint attached to each of the semiconductor elements.

### Advantageous Effects of Invention

By means of this invention, even when a plurality of semiconductor elements are installed on a mounting substrate, defects occurring at the time of mounting can be detected by the presence of heat generation in each of the semiconductor elements, and by excluding only semiconductor elements in which defects have occurred, a normally functioning semiconductor device can be obtained using only the remaining semiconductor elements. As a result, there are no longer cases in which when even one semiconductor element comprised by the semiconductor device is defective the entire device no longer functions and the remaining semiconductor elements are wasted, and manufacturing yields in device manufacturing can be improved.

### Brief Description of Drawings

Fig. 1 is an explanatory diagram explaining in summary the method for manufacturing semiconductor devices in a first embodiment;
Fig. 2 is a schematic diagram showing an example of mounting of SiC semiconductor chip;
Fig. 3 is a schematic diagram showing another example of mounting of SiC semiconductor chip;
Fig. 4 is an explanatory diagram explaining a system configuration to automatically exclude defective chips;
Fig. 5 is a flowchart showing the method for manufacturing semiconductor devices of the first embodiment;
Fig. 6 is an explanatory diagram explaining in summary the method for manufacturing semiconductor devices in a second embodiment; and
Fig. 7 is an explanatory diagram explaining in summary the method for manufacturing semiconductor devices in a third embodiment.

### Description of Embodiments

Below, the invention is explained in detail based on diagrams showing embodiments thereof.

### First Embodiment

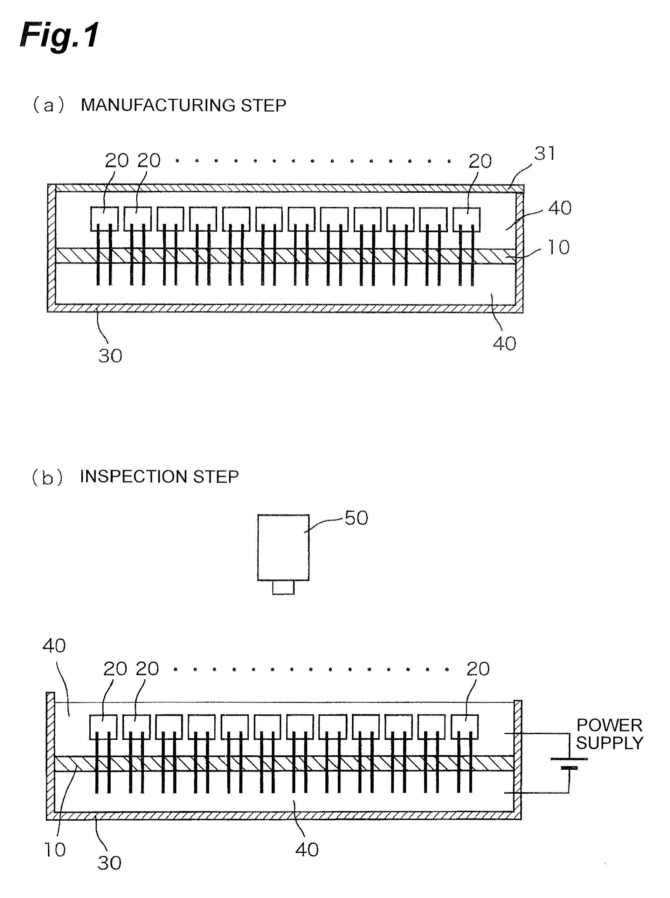

Fig. 1 is an explanatory diagram explaining in summary the method for manufacturing semiconductor devices in a first embodiment. The method for manufacturing semiconductor devices of this embodiment includes a mounting step (Fig. 1(a)) of forming, on a mounting substrate 10, a circuit comprising a plurality of SiC semiconductor chips 20 connected in parallel, and an inspection step (Fig. 1(b)) of inspecting whether defects have occurred in the mounted SiC semiconductor chips 20.

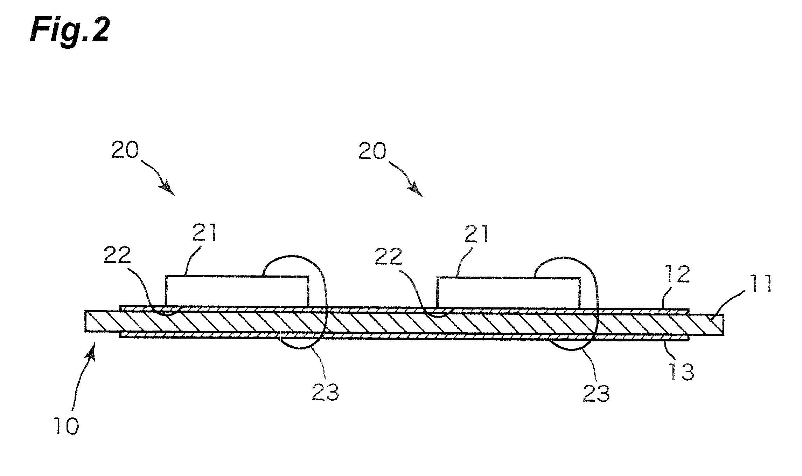

A SiC semiconductor chip 20 is a small-capacity chip having a current capacity on the order of 1 to 10 A. By connecting a plurality of SiC semiconductor chips 20 on a mounting substrate 10 in parallel, a semiconductor device (for example, a power device) with a large current capacity is realized. SiC semiconductor chips 20 are approximately 2 mm on a side, and are disposed in a linear form or a matrix form on the mounting substrate 10, with intervals of several millimeters. As the method of mounting the SiC semiconductor chips 20 on the mounting substrate 10, an appropriate method can be adopted according to the type of the SiC semiconductor chips 20. Fig. 2 is a schematic diagram showing an example of mounting of SiC semieonductor chips 20. In the example shown in Fig. 2, SiC diodes in which current flows in the thickness direction, having a front surface electrode 21 and rear surface electrode 22, are used as the mounted SiC semiconductor chips 20. As the mounting substrate 10, a silicon nitride, aluminum nitride or other insulating substrate 11 with printed wiring (metal faces 12 and 13) on the front and rear surface, can be used. The rear surface electrodes 22 of the SiC diodes are fixed using solder or conductive resin to the metal surface 12 on the front surface side of the mounting substrate 10, and the front surface electrodes 21 of the SiC diodes are wired by wire bonds 23 to the metal surface 13 on the rear surface side of the mounting substrate 10, to mount in parallel the plurality of SiC diodes on the mounting substrate 10.

The mounting substrate 10 with SiC diodes mounted is for example accommodated within a protective case 30 with an upper lid 31, and the space between the mounting substrate 10 and the protective case 30 is packed with a gel 40 having heat-dissipating, moisture-proofing and other properties.

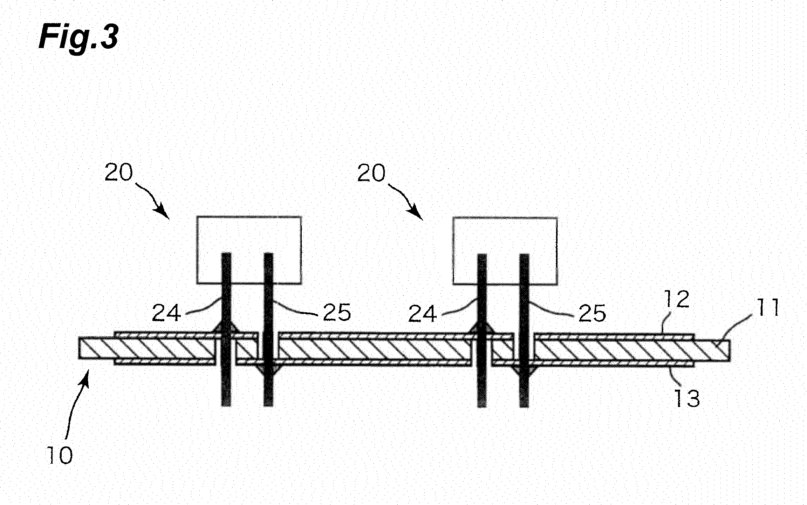

Fig. 3 is a schematic diagram showing another example of mounting of SiC semiconductor chips 20. In the example shown in Fig. 3, as the SiC semiconductor chips 20, SiC diodes having two terminals are used. As the mounting substrate 10, similarly to the above, a substrate with printed wiring (metal surfaces 12 and 13) formed on both faces of an insulating substrate 11 can be used. The two terminals 24 and 25 of the SiC diodes are soldered to the metal surface 12 and 13 on the front-surface side and rear-surface side of the mounting substrate 10 respectively, to mount the plurality of SiC diodes in parallel on the mounting substrate 10. The mounting substrata 10 with SiC diodes mounted is for example accommodated within a protective case 30 with an upper lid 31, and the space between the mounting substrate 10 and the protective case 30 is packed with a gel 40 having heat-dissipating, moisture-proofing and other properties.

The number of SiC semiconductor chips 20 mounted on the mounting substrate 10 is arbitrary, but it is desirable that a greater number of SiC semiconductor chips 20 than necessary be mounted taking into account anticipated defective chips, to satisfy the required current capacity. In Fig. 2 and Fig. 3, examples are explained in which SiC diodes are mounted as the SiC semiconductor chips 20, but chips to be mounted are not limited to diodes, and transistors may be used.

In the inspection step shown in Fig. 1(b), inspections are performed to determine whether defects have occurred in SiC semiconductor chips 20 mounted in the mounting step. Because defective chips cannot be discriminated by external appearance, it is not possible to identify and exclude defective chips visually. A defective chip is electrically short-circuited across the electrodes (terminals), and so in the present embodiment, this is used to identify defective chips. Specifically, first a voltage is applied across the electrodes (terminals) of each of the SiC semiconductor chips 20. Because a defective chip is short-circuited across the electrodes (terminals), a current of milliampere order flows by applying a voltage, and heat is generated thereby. By detecting this heat generation, defective chips are identified.

As means to detect heat generation in a defective chip, thermal imaging device 50 such as thermography in which an temperature distribution of the object is output as an image (picture), infrared microscope, or another can be used. As explained above, SiC semiconductor chips 20 are of size approximately 2 mm on a side, and are disposed on the mounting substrate 10 at intervals of several millimeters, so that the thermal imaging device 50 having a spatial resolution of 1 mm or lower is sufficient. By applying a voltage, a defective chip rises by approximately 5 to 10°C compared with the temperature (room temperature) of the surrounding mounting substrate 10 and other normal SiC semiconductor chips 20, and so the thermal imaging device 50 having a temperature resolution of approximately 1 °C or lower is sufficient. In the inspection step, the upper lid 31 of the protective case 30 is removed to capture a temperature distribution image using the thermal imaging device 50.

The temperature distribution image output from the thermal imaging device 50 is analyzed, and by identifying image regions on the mounting substrate 10 in which it is found that the temperature has risen, defective chips can be identified. When a defective chip has been identified in the inspection step, the wiring of the defective chip is removed and the chip is electrically insulated, and the semiconductor device comprising the other SiC semiconductor chips 20 is caused to function normally. That is, the semiconductor device is configured using the other SiC semiconductor chips 20, with defective chips excluded. In the prior art, among the mounted SiC semiconductor chips 20, when the electrodes (terminals) of any one SiC semiconductor chip 20 are short-circuited and the chip becomes defective, the device no longer functions as the intended semiconductor device, and the other SiC semiconductor chips 20 are wasted; but in the present embodiment, defective chips alone can be identified and excluded, so that the other normal SiC semiconductor chips 20 are not wasted, and the manufacturing yield at the time of mounting can be improved.

Exclusion of defective chips is performed by electrically insulating a SiC semiconductor chip 20 identified as defective from the other normal SiC semiconductor chips 20. To this end, the wiring of the SiC semiconductor chip 20 identified as defective is severed. Wiring severing may be performed manually by a human, or may be performed using a laser machining device 110 or other well-known device.

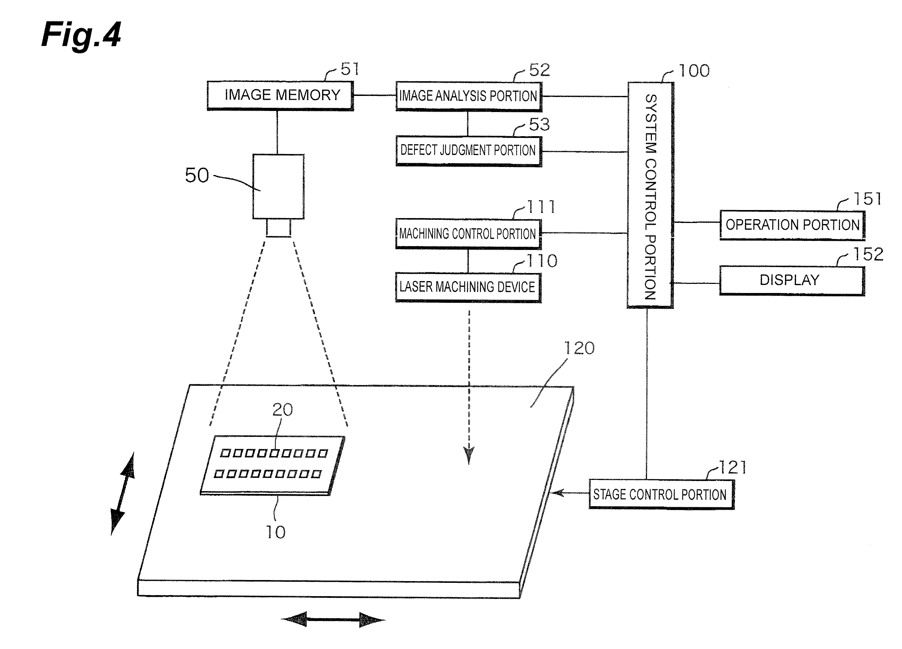

Fig. 4 is an explanatory diagram explaining a system configuration to automatically exclude defective chips. The system shown in Fig. 4 comprises a thermal imaging device 50 which captures temperature distribution images of a mounting substrate 10, a laser machining device 110 which severs defective chip wiring based on the results of analysis of a temperature distribution image obtained by the thermal imaging device 50, and an XY stage 120 on which a mounting substrate 10 for inspection is placed. This system further comprises a power supply (not shown) to apply a voltage to the SiC semiconductor chips 20 on the mounting substrate 10, an image analysis portion 52 and defect judgment portion 53 to analyze a temperature distribution image captured by the thermal imaging device 50, a machining control portion 111 to control operation of the laser machining device 110, and a stage control portion 121 to control operation of the XY stage 120.

The operation of each of these hardware portions is controlled by a system control portion 100. The system control portion 100 is connected to a display 152, which displays the temperature distribution image captured by the thermal imaging device 50 and information to be informed to an operator, and an operation portion 151 which receives operations from the operator.

The thermal imaging device 50 detects the surface temperature of the mounting substrate 10 placed on the XY stage 120, and generates and outputs a temperature distribution image which uses colors to represent the temperature distribution of the object. The temperature distribution image output from the thermal imaging device 50 is temporarily stored in an image memory 51. Prior to imaging of the mounting substrate 10 by the thermal imaging device 50, the XY stage 120 is used in position adjustment such that the positional relation between the thermal imaging device 50 and the mounting substrate 10 for inspection is settled.

The image analysis portion 52 performs image analysis of the temperature distribution image stored temporarily in the image memory 51. Specifically, processing to extract, from the temperature distribution image, image regions in which the temperature is higher by 5 to 10°C compared with the surroundings, and processing to identify the positions within the temperature distribution image of the extracted image regions, are performed. The specified positions may be absolute positions within the temperature distribution image, or may be positions relative to some reference position provided in advance. The image analysis portion 52 notifies the defect judgment portion 53 of the results of extraction of image regions, and notifies the system control portion 100 of position information indicating the positions of image regions.

The defect judgment portion 53 judges whether defective chips are included in the mounting substrate 10 for inspection based on the notification from the image analysis portion 52. If extraction results notified by the image analysis portion 52 indicate that an image region in which the temperature is 5 to 10°C higher than the surroundings has been extracted, the defect judgment portion 53 judges that a defective chip exists on the inspected mounting substrate 10 for inspection, and if the extraction result notified from the image analysis portion 52 indicates that an image region was not extracted, the defect judgment portion 53 judges that defective chips do not exist. The defect judgment portion 53 notifies the system control portion 100 of the judgment results.

If a judgment result indicating that a defective chip exists on the mounting substrate 10 is received from the defect judgment portion 53, the system control portion 100 generates a control command to control the XY stage 120 based on position information notified from the image analysis portion 52, and sends the control command to the stage control portion 121. The stage control portion 121 controls the XY stage 120 based on the control command, and performs position adjustment such that the mounting substrate 10 is in a position opposing the laser machining device 110. In order to sever the wiring of defective chips, the system control portion 100 sends control commands to the machining control portion 111 to control the laser machining device 110, while making fine adjustments in the position of the mounting substrate 10 through control of the XY stage 120, and irradiates target wiring portions with laser light to sever wiring.

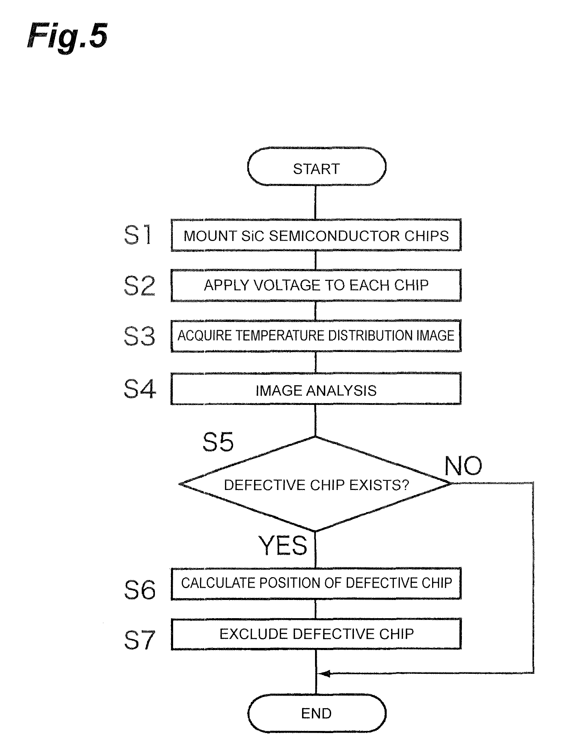

Fig. 5 is a flowchart showing the method for manufacturing semiconductor devices of this embodiment. In the mounting step, mounting of SiC semiconductor chips 20 onto the mounting substrate 10 is performed (step S1). In this embodiment, mounting on the mounting substrate 10 is performed such that the plurality of SiC semiconductor chips 20 are connected in parallel. In the mounting step, a subsequent step of accommodating the mounting substrate 10 in a protective case 30, and a step of packing gel 40 to protect the chips on the mounting substrate 10, and the other steps are performed.

After ending the mounting step, the inspection step, explained below, is performed. In the inspection step, first a voltage is applied to each of the SiC semiconductor chips 20 on the mounting substrate 10 (step S2). Any means may be used for voltage application, but voltage is applied across the electrodes (terminals) of each of the SiC semiconductor chips 20 such that the voltage is applied simultaneously to all of the SiC semiconductor chips 20. In order to capture a temperature distribution image in the next step, by controlling the stage control portion 121, positioning is performed by the XY stage 120 such that the mounting substrate 10 for inspection is within the image capture region of the thermal imaging device 50.

When an appropriate amount of time has elapsed after applying the voltage, the thermal imaging device 50 is used to capture an image from the front-surface side of the mounting substrate 10, and a temperature distribution image of the mounting substrate 10 is acquired (step S3). The acquired temperature distribution image is temporarily stored in the image memory 51. The image analysis portion 52 performs image analysis of the temperature distribution image stored temporarily in the image memory 51 (step S4).

Based on the results of image analysis by the image analysis portion 52, the defect judgment portion 53 judges whether there exist SiC semiconductor chips 20 the temperature of which is high compared with the surface of the mounting substrate 10 and the other SiC semiconductor chips 20, to judge the presence of defective chips (step S5). If it is judged that there exist no defective chips among the mounted SiC semiconductor chips 20 ("NO" in S5), processing according to the flowchart halts.

If it is judged that there exist defective chips among the mounted SiC semiconductor chips 20 ("YES" in S5), the image analysis portion 52 identifies the positions of defective chips based on the temperature distribution image stored in the image memory 51, and calculates the defective chip positions on the mounting substrate 10 (step S6). Calculation of defective chip positions may be performed together with the image analysis of step S4.

The system control portion 100 is notified of the calculated defective chip position information. The system control portion 100 decides the defective chip wiring to be severed based on the defective chip position information notified from the image analysis portion 52, and controls the stage control portion 121 and the machining control portion 111 to exclude the defective chips by severing the target wiring (step S7). For example, position adjustment by the XY stage 120 is performed such that the position of wiring to be severed coincides with the laser irradiation position of the laser machining device 110, and in a state in which the XY stage 120 is fixed, laser irradiation is performed to sever the target wiring. Or, after position adjustment by the XY stage 120 such that the position of the wiring for severing is in proximity to the laser irradiation position, laser irradiation is performed, the XY stage 120 is moved such that the wiring to be severed passes through the laser irradiation position, and the target wiring is severed.

In the flowchart shown in Fig. 5, a procedure is shown in which defective chips are identified from image analysis of the temperature distribution image and defective chips are excluded automatically; however, in a portion of the procedure, operations by an operator may be allowed. For example, processing may be performed up to step S6, in which defective chip positions are calculated based on the image analysis of the temperature distribution image, and an operator may be notified of defective chip position information via a display 152. The operator may perform an operation to sever defective chip wiring, excluding defective chips, based on the information notified via the display 152.

The temperature distribution image acquired by the thermal imaging device 50 may be displayed on the display 152, without analysis of the temperature distribution image by the image analysis portion 52 or judgment of the presence of defective chips by the defect judgment portion 53. In the temperature distribution image, the existence of defective chips at which the temperature is higher than the surroundings can be indicated by a display color which is different from that of the surroundings. Hence an operator can visually confirm the existence of a defective chip from the temperature distribution image, without relying on image analysis. Further, operation of the XY stage 120 and laser machining device 110 is accepted via the operation portion 151, so that defective chip wiring can be severed while viewing the temperature distribution image displayed on the display 152.

### Second Embodiment

In the first embodiment, a method was explained in which thermography, infrared microscope, or another thermal imaging device 50 is used to identify defective chips; however, as means to detect heat generation in defective chips, thermolabels, thermopaint, or another heat-revealing member, the color of which changes due to heat generation, can also be used. In this embodiment, a method is explained in which thermolabels, thermopaint, or another heat-revealing member is used to identify defective chips.

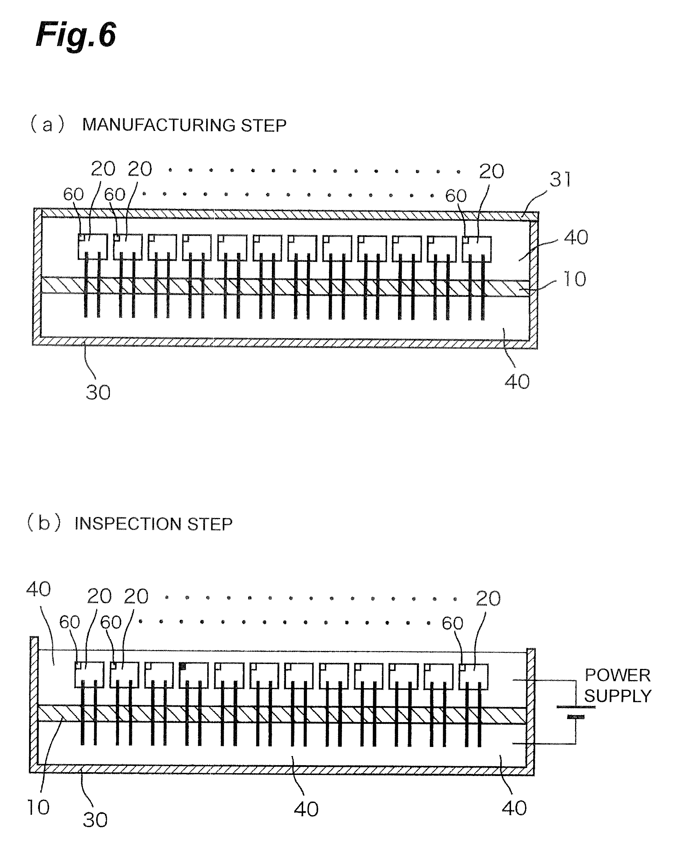

In the second embodiment, the presence of heat generation in each of the SiC semiconductor chips 20 is detected using thermolabels, thermopaint, or another heat-revealing member. Fig. 6 is an explanatory diagram explaining in summary the method for manufacturing semiconductor devices of the second embodiment. Similarly to the first embodiment, the method for manufacturing semiconductor devices of the second embodiment includes a mounting step (Fig. 6(a)) of forming a circuit on a mounting substrate 10 in which a plurality of SiC semiconductor chips 20 are connected in parallel, and an inspection step (Fig. 6(b)) of inspecting to determine whether a defect has occurred in the mounted SiC semiconductor chips 20.

The mounting step differs from that of the first embodiment in including a step, either prior to mounting or after mounting the SiC semiconductor chips 20, of attaching thermolabels, thermopaint, or another heat-revealing member 60 onto each of the SiC semiconductor chips 20; otherwise the step is similar to that of the first embodiment. When attaching thermolabels to each of the SiC semiconductor chips 20, adhesive tape or another adhesive member is used in affixing to the surface of the SiC semiconductor chips 20. When using thermopaint, the termopaint may be painted to the surface of the SiC semiconductor chips 20.

In the inspection step, the presence of heat generation in each of the SiC semiconductor chips 20 at the time of voltage application is detected from changes in the color of the heat-revealing member 60 attached to each of the SiC semiconductor chips 20, and defective chips are identified. In the second embodiment, a heat-revealing member 60 is attached, so that the presence of defective chips can be confirmed visually by an operator. When confirming the existence of defective chips, manual operations are used to remove wiring and insulate defective chips. In Fig. 6(b), a state is shown in which there is a temperature increase in the fourth SiC semiconductor chip 20 from the left end, and the color of the heat-revealing member 60 is changed.

In the inspection step, image capture of the mounting substrate 10 in a state with a voltage applied may be performed from the front-surface side using a CCD camera or other imaging device, and the image obtained (color image or monochromatic image) may be analyzed to detect changes in the color of the heat-revealing member 60 attached to each of the SiC semiconductor chips 20. In this case, by constructing a system similar to that of Fig. 4 of the first embodiment, defective chips can be identified and defective chip wiring can be severed automatically.

### Third Embodiment

As the means of detecting heat generation in a defective chip, in addition to thermography, infrared microscope or another thermal imaging device 50 and thermolabels, thermopaint or another heat-revealing member 60, a temperature sensor using a thermocouple, thermistor, or similar can also be employed. In this embodiment, a method is explained in which a temperature sensor using a thermocouple, thermistor or similar is employed to identify defective chips.

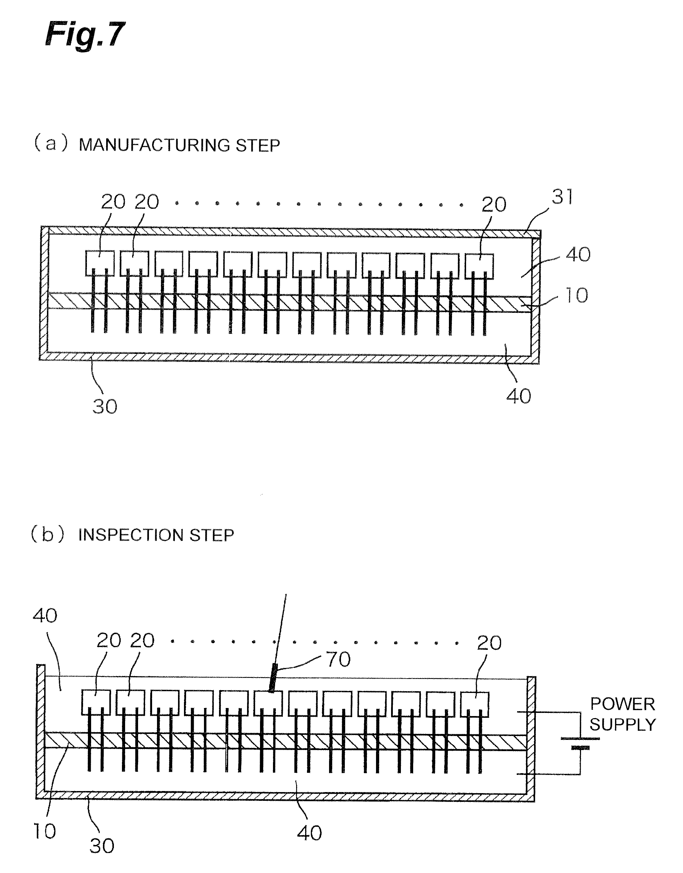

In the third embodiment, a thermocouple, thermistor, or other temperature sensor is used to detect the presence of heat generation in each of the SiC semiconductor chips 20. Fig. 7 is an explanatory diagram explaining in summary the method for manufacturing semiconductor devices in the third embodiment. Similarly to the first embodiment, the method for manufacturing semiconductor devices of the third embodiment includes a mounting step (Fig. 7(a)) of forming a circuit on a mounting substrate 10 in which a plurality of SiC semiconductor chips 20 are connected in parallel, and an inspection step (Fig. 7(b)) of inspecting for the occurrence of defects in the mounted SiC semiconductor chips 20.

The mounting step is entirely the same as in the first embodiment. In the inspection step, the temperature sensor 70 is brought into contact with the surface of each SiC semiconductor chip 20, and each time this contact is implemented, the surface temperature is measured. If a measurement result indicates that the surface temperature of the SiC semiconductor chip 20 is higher by 5 to 10°C than room temperature, the chip is judged to be defective, and a manual operation is performed to remove the wiring of and insulate the defective chip.

A measurement device in which temperature sensors 70 are disposed in the same number as the number of SiC semiconductor chips 20 may also be configured, and this measurement device may be used in measurement of the temperatures of the SiC semiconductor chips 20 all at once. In this case, based on measurement results by the measurement device, the presence of defective chips can be judged, and by constructing a system similar to that of Fig. 4 in the first embodiment, defective chips can be identified and the defective chip wiring can be severed automatically.

In the first to the third embodiments, methods were explained in which SiC semiconductor chips 20 are used to manufacture a semiconductor device; but the invention is not limited to SiC semiconductor chips 20, and small-capacity chips including GaN (gallium nitride) or diamond can be used to manufacture a semiconductor device by a manufacturing method similar to those above.

Further, in the first to the third embodiments, semiconductor devices were explained in which a plurality of SiC semiconductor chips 20 are connected in parallel; but in addition to SiC semiconductor chips 20, the semiconductor device may of course have mounted control circuits, driving circuits, protective circuits, and similar as appropriate.

Further, when semiconductor elements are elements including SiC, GaN, or diamond, even when it is difficult to enlarge the chip area and semiconductor elements with small current capacities are used, by connecting numerous semiconductor elements in parallel, a large current capacity for the device overall can be realized, and application as various power devices becomes possible.

Further, in the first to the third embodiments, a plurality of diodes or transistors are connected in parallel to configure a semiconductor device, but even when the current capacities of each of the semiconductor elements are small, a large current capacity can be realized for the device overall, and application as various power devices is possible.

Further, in the first embodiment, thermography or infrared microscope is used as the means of detecting the presence of heat generation in semiconductor elements, so that the temperature distribution image generated by these thermal imaging devices can be displayed on a display device or analyzed by an analysis device to detect the presence of heat generation. Further, in the third embodiment, a thermocouple, thermistor or other temperature sensor is used as the means of detecting the presence of heat generation in semiconductor elements, so that the presence of heat generation can be detected by, for example, changes in a voltage.

Further, in the second embodiment, the presence of heat generation in each of the semiconductor elements can be detected from a change in the color of thermolabels or thermopaint attached to each of the semiconductor elements. Because the presence of heat generation can be detected visually, in addition to inspections at the time of product shipment, the occurrence of defects in each of the semiconductor elements can easily be discovered even at the time of product use.

### Industrial Applicability

This invention can be used as a method for manufacturing semiconductor devices in which defective chips occurring in a mounting step can be visually identified, and the defective chips can be excluded.

### Reference Signs List

- 10: Mounting substrate
- 20: SiC semiconductor chip
- 30: Protective case
- 50: Thermal imaging device
- 60: Heat-revealing member
- 70: Temperature sensor

## Claims

1. A method for manufacturing a semiconductor device,
the method including a step of forming, on a substrate, a circuit formed of a plurality of semiconductor elements connected in parallel, and an inspection step of inspecting the semiconductor elements forming the circuit, wherein
the inspection step includes:
a step of applying a voltage to each of the semiconductor elements included in the circuit formed on the substrate;
a step of detecting whether there is heat generation in each of the semiconductor elements as a result of the application of a voltage; and
a step of severing a connection between a semiconductor element for which heat generation has been detected and another semiconductor element.

2. The method for manufacturing a semiconductor device according to Claim 1, wherein the semiconductor elements are elements including SiC, GaN, or diamond.

3. The method for manufacturing a semiconductor device according to Claim 2, wherein the semiconductor elements are diodes or transistors.

4. The method for manufacturing a semiconductor device according to any one of Claims 1 to 3, wherein the presence of heat generation in each of the semiconductor elements is detected by thermography, an infrared microscope, or a temperature sensor.

5. The method for manufacturing a semiconductor device according to any one of Claims 1 to 3, wherein
a thermolabel or thermopaint is attached to each of the semiconductor elements, and
the presence of heat generation in each of the semiconductor elements is detected by a change in a color of the thermolabel or thermopaint.
